(19) Europäisches Patentamt / European Patent Office / Office européen des brevets

(11) **EP 2 208 201 B1**

(12) **FASCICULE DE BREVET EUROPEEN**

(45) Date de publication et mention de la délivrance du brevet:
**04.09.2013 Bulletin 2013/36**

(21) Numéro de dépôt: **08846719.6**

(22) Date de dépôt: **07.11.2008**

(51) Int Cl.:
*G11C 11/412* (2006.01)   *H01L 21/8244* (2006.01)
*H01L 21/84* (2006.01)   *H01L 27/11* (2006.01)
*H01L 27/12* (2006.01)   *H01L 29/786* (2006.01)

(86) Numéro de dépôt international:
**PCT/EP2008/065103**

(87) Numéro de publication internationale:
**WO 2009/060052 (14.05.2009 Gazette 2009/20)**

(54) **CELLULE MEMOIRE SRAM DOTEE DE TRANSISTORS A STRUCTURE MULTI-CANAUX VERTICALE**

SRAM-SPEICHERZELLE MIT TRANSISTOREN MIT EINER VERTIKALEN MEHRKANALSTRUKTUR

SRAM MEMORY CELL EQUIPPED WITH TRANSISTORS HAVING A VERTICAL MULTI-CHANNEL STRUCTURE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **09.11.2007 FR 0758935**

(43) Date de publication de la demande:
**21.07.2010 Bulletin 2010/29**

(73) Titulaire: **Commissariat à l'Énergie Atomique et aux Énergies Alternatives
75015 Paris (FR)**

(72) Inventeurs:
• **THOMAS, Olivier**
  **F-38420 Revel (FR)**
• **ERNST, Thomas**
  **F-38210 Morette (FR)**

(74) Mandataire: **Ilgart, Jean-Christophe et al
BREVALEX
95 rue d'Amsterdam
75378 Paris Cedex 8 (FR)**

(56) Documents cités:
WO-A-2006/108987     US-A- 5 965 914
US-A1- 2005 094 434     US-A1- 2005 161 739
US-A1- 2007 196 973

**Description**

**DOMAINE TECHNIQUE**

L'invention se rapporte au domaine de la microélectronique et en particulier à celui des mémoires statiques à accès aléatoire (SRAM pour « static random acces memory »). Elle concerne notamment une cellule mémoire SRAM comprenant une pluralité de transistors à structure multi-canaux verticale, chaque transistor ayant un nombre de canaux adapté en fonction du rôle de ce transistor dans la cellule, et du nombre de canaux affecté aux autres transistors de la cellule.

L'invention permet la mise en oeuvre d'une cellule mémoire SRAM à 6 transistors appelée cellule « 6T » présentant une stabilité en lecture et une marge en écriture améliorées, par rapport à une cellule 6T classique à encombrement identique.

L'invention est susceptible de s'adapter à d'autres dispositifs, et peut être mise en oeuvre, notamment, dans des circuits formant une ou plusieurs portes logiques et comprenant des transistors à structure multi-canaux verticale, chaque transistor ayant un nombre de canaux adapté en fonction de son rôle de dans le circuit.

**ÉTAT DE LA TECHNIQUE ANTÉRIEURE**

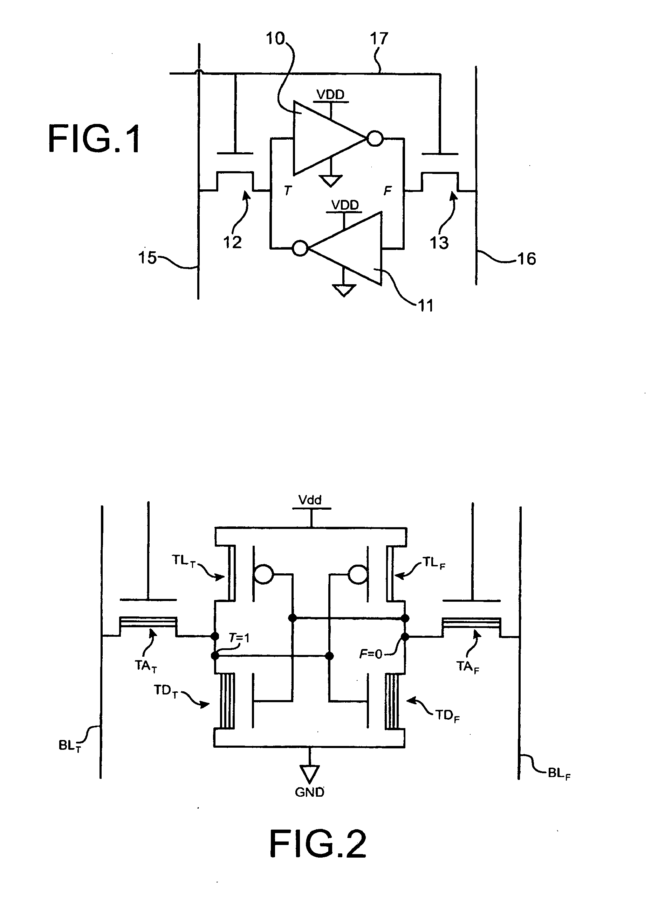

Une cellule mémoire SRAM classique (SRAM pour « static random access memory » ou mémoire vive statique) comprend généralement deux inverseurs 10, 11, connectés selon une configuration dite « de bascule. ». ou « flip-flop » et deux transistors d'accès 12, 13 connectés à des lignes dites de bit 15 et 16, et commandés par une ligne de mot 17 (figure 1).

Les caractéristiques recherchées pour une cellule mémoire sont :

- une bonne stabilité lors des différentes opérations de lecture, d'écriture, de rétention, effectuées sur la cellule,
- un courant de conduction ou de charge le plus important possible pour donner à la cellule une vitesse de fonctionnement élevée,
- une taille de cellule la plus faible possible pour permettre de réaliser une mémoire avec une densité d'intégration de cellules importante,
- un courant en rétention le plus faible possible afin de minimiser la puissance consommée statique.

Ces critères sont contradictoires entre eux et amènent les concepteurs de mémoires à faire des compromis.

Les cellules SRAM à six transistors appelées cellules « 6T », offrent un bon compromis entre tous les critères précités.

Cependant, en cherchant à réduire de plus en plus les tailles des transistors des cellules mémoires, les paramètres de ces transistors tels que leur largeur W de canal, leur longueur L de canal, leur tension de seuil $V_T$, leur perméabilité $\mu_0$, leur dopage Na, leur épaisseur d'oxyde de grille Tox, fluctuent. Cela entraîne, comme indiqué dans les documents [TAK01] et [YAM04] (référencés à la fin de la présente description), une augmentation de la sensibilité des cellules mémoires face aux différentes sources de bruit telles que le couplage capacitif, le couplage inductif, le bruit d'alimentation.

Le développement d'une cellule mémoire présentant une marge au bruit élevée devient donc de plus en plus une priorité.

Pour les cellules mémoire 6T conventionnelles, la stabilité des cellules est déterminée par leur marge au bruit statique (SNM) en mode lecture. En effet, lors d'un accès en lecture, le gain des inverseurs de la cellule a tendance à être diminué par la mise en conduction des transistors d'accès. Pour annuler cet effet, des cellules à 8 ou 10 transistors présentant une stabilité en lecture améliorée ont été proposées. Cependant, malgré une forte amélioration de la marge au bruit statique SNM, les cellules à 10 transistors et à 8 transistors, ont un encombrement important par rapport aux cellules 6T, typiquement de l'ordre de 30 % supérieur à celui des cellules 6T.

Il est connu de réaliser un dispositif microélectronique à transistors comportant plusieurs canux. Le document US 2005/0161739 évoque par exemple des structures de transistors comportant plusieurs « fins ».

Par ailleurs, pour répondre à des problématiques d'encombrement, il est connu de former un transistor comportant une structure multicanaux, avec une disposition verticale de barreaux semi-conducteurs parallèles répartis dans une direction orthogonale au plan principal d'un substrat. Cela est décrit par exemple dans le document WO 2006/108987 A1 et US 5965914.

Il se pose le problème de trouver une nouvelle structure de cellule mémoire SRAM, présentant d'une part une stabilité en lecture (SNM) améliorée par rapport aux cellules 6T classiques, tout en conservant un encombrement satisfaisant et éventuellement amélioré.

## EXPOSÉ DE L'INVENTION

La présente invention concerne un dispositif microélectronique selon la revendication 1.

Selon une possibilité de mise en oeuvre, ledit élément peut être une cellule de mémoire RAM comportant:

- au moins un premier transistor d'accès et au moins un deuxième transistor d'accès dotés respectivement d'un nombre de m canaux parallèles dans une direction réalisant un angle non-nul et de préférence orthogonale, avec le plan principal du substrat,
- une pluralité de transistors formant une bascule dont au moins un transistor de conduction et au moins un autre transistor de conduction dotés respectivement d'un nombre de n canaux parallèles dans une direction réalisant un angle non-nul et de préférence orthogonale, avec le plan principal du substrat, n étant supérieur à m.

Une cellule ayant une stabilité en lecture améliorée peut être ainsi obtenue.

Selon une possibilité de mise en oeuvre, ledit élément peut être une cellule de mémoire SRAM comportant :

- au moins un transistor d'accès et au moins un autre transistor d'accès dotés respectivement d'un nombre de m canaux parallèles dans une direction, de préférence orthogonale, réalisant un angle non-nul avec le plan principal du substrat,
- une pluralité de transistors formant une bascule, dont au moins un transistor de charge et au moins un autre transistor de charge dotés respectivement d'un nombre k, de canaux parallèles dans une direction réalisant un angle non-nul et de préférence orthogonale, avec le plan principal du substrat, k étant prévu inférieur à m.

Une cellule ayant une marge en écriture améliorée peut être ainsi obtenue.

Selon une possibilité de mise en oeuvre, ledit élément est une cellule de mémoire SRAM comportant :

- au moins un transistor d'accès et au moins un autre transistor d'accès dotés respectivement d'un nombre de m canaux parallèles dans une direction réalisant un angle non-nul et de préférence une direction orthogonale avec le plan principal du substrat,
- au moins un transistor de conduction et au moins un autre transistor de conduction dotés respectivement d'un nombre de n canaux parallèles dans une direction réalisant un angle non-nul et de préférence une direction orthogonale, avec le plan principal du substrat, n étant supérieur à m,
- au moins un transistor de charge et au moins un autre transistor de charge dotés respectivement d'un nombre de k canaux parallèles dans une direction réalisant un angle non-nul et de préférence une direction orthogonale, avec le plan principal du substrat, k étant prévu inférieur à m.

Une cellule ayant une stabilité en lecture et une marge en écriture améliorées peut être ainsi obtenue.

Selon une possibilité de mise en oeuvre du dispositif, ledit élément peut être une porte logique ou un circuit comportant une ou plusieurs portes logiques.

Dans ce cas, la première pluralité de transistors peut être formée de transistors pour lesquels on privilégie un courant débité élevé, tandis que les transistors de la deuxième pluralité de transistors peuvent être des transistors pour lesquels on privilégie une puissance dynamique importante.

On peut mettre en oeuvre un nombre de canaux plus restreints pour la deuxième pluralité de transistors afin de diminuer la capacité d'entrée de la porte logique.

Selon une possibilité, la première pluralité de transistors peut être formée de transistors d'un premier type parmi un type N ou un type P, tandis que les transistors de la deuxième pluralité de transistors sont formés de transistors d'un deuxième type, parmi un type P ou un type N, et différent du premier type.

L'invention concerne également la mise en oeuvre d'un procédé de réalisation d'un dispositif microélectronique selon la revendication 7.

Les m canaux des premier(s) transistor(s) peuvent être formés dans un premier empilement de m couches semi-conductrices.

Les n canaux des deuxième(s) transistor(s) peuvent être formés dans un deuxième empilement de n couches semi-conductrices.

Selon l'invention ledit premier empilement et ledit deuxième empilement sont de même hauteur.

Cela peut permettre d'éviter des inconvénients liés à un défaut de planéité du dispositif formé par l'ensemble des transistors.

Ledit deuxième empilement peut comporter des couches semi-conductrices d'épaisseurs différentes.

Le premier empilement et le deuxième empilement peuvent être formés chacun d'une alternance de couches semi-conductrices à base d'un premier matériau semi-conducteur et de couches semi-conductrices à base d'un deuxième matériau semi-conducteur.

Selon une possibilité, lesdits éléments peuvent être des cellules d'une mémoire SRAM.

Selon une possibilité, lesdits éléments peuvent former une porte logique ou un circuit comportant une ou plusieurs portes logiques.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de cellule mémoire vive statique suivant l'art antérieur,
- la figure 2 illustre un exemple de cellule mémoire 6T, dotée de 6 transistors multi-canaux, dont deux transistors d'accès à m canaux, deux transistors de conduction à n canaux, et deux transistors de charge à k canaux (avec k < m < n),
- les figures 3A-3F, illustrent un exemple de procédé de réalisation de plusieurs transistors à structure multi-canaux verticale ayant un nombre de canaux superposés différents et reposant sur un même substrat,
- les figures 4A, 4B, illustrent respectivement :
- un premier exemple transistor à structure multi-canaux verticale formé d'une pluralité de barreaux semi-conducteurs associée à une grille située par-dessous et par-dessus les barreaux,
- un deuxième exemple transistor à structure multi-canaux verticale formé d'une pluralité de barreaux semi-conducteurs associée à une grille enrobante autour des barreaux,

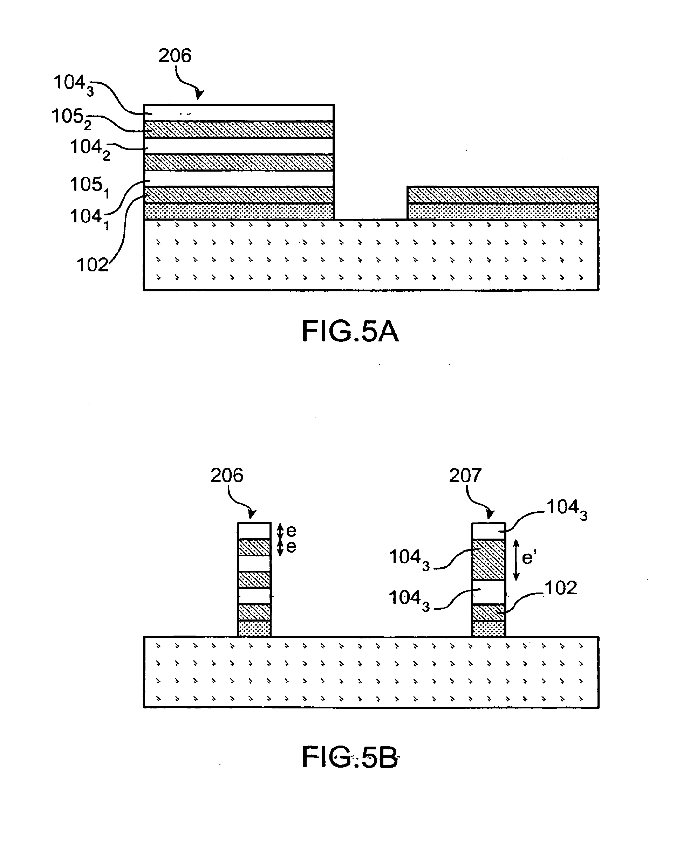

- les figures 5A-5B, illustrent un autre exemple de procédé de réalisation de plusieurs transistors à structure multi-canaux verticale ayant un nombre de canaux superposés différents et reposant sur un même substrat suivant l'ivention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

Un exemple de dispositif microélectronique sous forme d'une cellule mémoire SRAM à six transistors multi-canaux, va à présent être décrit en liaison avec la figure 2.

La cellule comprend un premier transistor de charge $TL_T$ et un deuxième transistor de charge $TL_F$, par exemple de type PMOS, et comportant respectivement un nombre prévu ou prédéterminé de k canaux (avec k un entier supérieur ou égal à 1). Les k canaux des transistors $TL_T$ et $TL_F$ peuvent être sous forme d'une pluralité de fils, ou de barreaux, ou de blocs parallélépipédiques ou cylindriques reliant respectivement une zone de source et une zone de drain, et disposés parallèles entre eux et à un substrat sur lequel sont formés les transistors. Les fils, ou barreaux, ou blocs, sont également alignés dans une direction réalisant un angle non-nul avec le plan principal du substrat, de préférence une direction orthogonale au plan principal du substrat, et forment ainsi une structure à plusieurs canaux que l'on appelle structure « multi-canaux verticale ».

La cellule est également dotée d'un premier transistor d'accès $TA_T$ et d'un deuxième transistor d'accès $TA_F$, par exemple de type NMOS comprenant chacun un nombre prévu ou prédéterminé de m canaux. Le nombre m de canaux prévus pour les transistors d'accès $TA_T$ et $TA_F$ est différent de celui k des transistors de charge $TL_T$ et $TL_F$, et peut être tel que m $\geq$ k.

Les m canaux des transistors d'accès $TA_T$ et $TA_F$ sont également sous forme de fils, ou de barreaux, ou de blocs, parallèles entre eux et au substrat, et alignés dans une direction réalisant un angle non-nul avec le plan principal du substrat, en particulier une direction orthogonale au plan principal du substrat. Les m canaux peuvent ainsi réaliser également une structure multi-canaux verticale à m canaux.

La cellule comprend également un premier transistor de conduction $TD_T$ et un deuxième transistor de conduction $TD_F$ par exemple de type NMOS et comprenant un nombre prévu ou prédéterminé de n canaux.

Les n canaux des transistors $TD_T$ et $TD_F$ sont également sous forme de fils, ou de barreaux, ou de blocs, parallèles entre eux et au substrat, et alignés dans une direction orthogonale au plan principal du substrat. Ces fils, ou barreaux, ou blocs, réalisent une structure multi-canaux verticale à n canaux.

Le nombre n de canaux prédéterminé des transistors de conduction $TD_T$ et $TD_F$, est différent de celui k des transistors de charge $TL_T$ et $TL_F$, et de celui m des transistors d'accès $TA_T$ et $TA_F$. Le nombre m de canaux prévu pour les transistors d'accès $TA_T$ et $TA_F$, peut être choisi en fonction du nombre n de canaux pour les transistors de conduction

$TD_T$ et $TD_F$ et de celui k pour les transistors de charge $TL_T$ et $TL_F$.

Le nombre n de canaux prévus pour les transistors de conduction $TD_T$ et $TD_F$ est de préférence supérieur à celui m des transistors d'accès $TA_T$ et $TA_F$.

Le nombre de canaux des différents transistors de la cellule est de préférence tel que : $n > m \geq k$.

Les transistors de charge $TL_T$, $TL_F$ et de conduction $TD_T$, $TD_F$ sont agencés de manière à former un bistable, prévu pour contrôler et maintenir une information gardée par un premier noeud de stockage T, et un deuxième noeud de stockage F de la cellule. Le premier noeud de stockage T, peut être destiné à conserver une information logique donnée, tandis que le deuxième noeud de stockage F est destiné à garder une information logique complémentaire de ladite information logique.

Les transistors de charge $TL_T$ et $TL_F$, peuvent être connectés à une tension d'alimentation VDD, et ont pour fonction de maintenir un niveau logique '1', par exemple- égal à un potentiel VDD, à l'un ou l'autre des noeuds de stockage T et F de la cellule, en fonction d'une valeur logique mémorisée.

Les transistors de conduction $TD_T$ et $TD_F$, peuvent être connectés à un potentiel de masse GND, et avoir pour rôle, celui de maintenir un niveau logique '0', par exemple égal au potentiel GND, à l'un ou l'autre des noeuds stockage en fonction de la valeur logique mémorisée. Le premier transistor de charge $TL_T$ et le premier transistor de conduction $TD_T$ forment un premier inverseur pour la cellule, tandis que le deuxième transistor de charge $TL_F$ et le deuxième transistor de conduction $TD_F$ forment un deuxième inverseur. Dans cet exemple, un niveau logique '1' est mémorisé au premier noeud T de la cellule.

Les deux transistors d'accès $TA_T$ et $TA_F$, ont quant à eux pour fonction d'autoriser, lors d'un cycle de lecture ou d'écriture, l'accès aux potentiels des noeuds de stockage T et F.

Les grilles respectives du premier transistor d'accès $TA_T$ et du deuxième transistor d'accès $TA_F$ sont reliées à une ligne de mot WL apte à acheminer un signal de polarisation, et qui est dédiée aux opérations d'écriture et de lecture de la cellule.

Le premier transistor d'accès $TA_T$ est connecté à une ligne de bit $BL_T$, tandis que le deuxième transistor d'accès $TA_F$ est connecté à une deuxième ligne de bit $BL_F$.

Dans cette cellule, le nombre de canaux d'un transistor donné est prévu ou prédéterminé en fonction du rôle de ce transistor dans la cellule, et du nombre de canaux prévus pour les autres transistors.

Un exemple de fonctionnement de la cellule est le suivant :

En mode de rétention, la ligne de mot WL est maintenue à un potentiel de masse GND. Les transistors d'accès $TA_T$ et $TA_F$ sont alors placés dans un état bloqué de sorte que l'on ne peut accéder à la cellule mémoire ni en lecture, ni en écriture.

Pour une mise en mode lecture, les lignes de bit $BL_T$ et $BL_F$ de la cellule sont préalablement chargées au potentiel VDD. Puis, afin de permettre un accès en lecture des noeuds de stockage T et F, la ligne de mot WL est mise au potentiel VDD. Les lignes de bit $BL_T$ et $BL_F$ peuvent quant à elles être laissées flottantes.

La stabilité de la cellule en mode lecture dépend de l'amplitude de la tension du noeud de stockage dédié au maintien du niveau logique '0', par exemple le deuxième noeud F. Cette tension doit de préférence rester inférieure à la tension de commutation du premier inverseur connecté au noeud de stockage dédié au maintien du niveau logique '1', par exemple le premier noeud T. Cette condition est liée au diviseur de tension entre la deuxième ligne de bit $BL_F$ et la masse de la cellule GND, formé par le deuxième transistor d'accès $TA_F$ et le deuxième transistor de conduction $TD_F$ connectés au deuxième noeud de niveau logique '0'.

Pour améliorer la marge au bruit en lecture, les transistors de la cellule peuvent être mis en oeuvre de sorte que le courant linéaire qui traverse le deuxième transistor de conduction $TD_F$ est supérieur au courant de saturation du transistor d'accès $TA_F$.

Dans une cellule 6T classique, le ratio de gain en courant r, entre les transistors de conduction et d'accès $r=(W/L)_{TD}/(W/L)_{TA}$ peut être par exemple de l'ordre de 2 pour une technologie sur substrat massif (communément appelée « Bulk ») avec une dimension critique de grille de l'ordre de 90 nm.

Pour une structure multi-canaux verticale, ce ratio r peut être estimé avec $(W/L)_{TD}$ le rapport de la largeur cumulée de tous les canaux sur la longueur d'un desdits canaux d'un transistor de conduction et $(W/L)_{TA}$ le rapport de la largeur cumulée de tous les canaux sur la longueur d'un desdits des canaux d'un transistor d'accès. Pour les technologies de grilles de dimension critique inférieure à 65 nm, ce ratio r peut être supérieur à 2 ou à 3, ce qui impact le gain en densité des cellules mémoire.

Une co-intégration de transistors d'accès $TA_T$ et $TA_F$ dotés d'une structure multi-canaux verticale comportant m canaux, et de transistors de conduction $TD_T$ et $TD_F$ dotés d'une structure multi-canaux verticale comportant n canaux, avec un nombre n de canaux plus élevé que celui m des transistors d'accès, permet d'obtenir un ratio r plus élevé que celui des structures de cellules 6T classiques, à encombrement égal ou surface égale de la cellule mémoire occupée sur le substrat. Cela permet ainsi d'améliorer la marge au bruit en lecture de la cellule. Une telle co-intégration peut également permettre d'obtenir un même ratio r qu'avec les cellules suivant l'art antérieur, pour un encombrement inférieur. On peut ainsi obtenir une même marge au bruit qu'avec une cellule classique pour un encombrement plus faible.

Pour une mise en mode écriture, une des deux lignes de bit est préchargée au potentiel VDD, par exemple la deuxième ligne de bit $BL_F$, tandis que la ligne de bit complémentaire $BL_T$ peut quant à elle être polarisée au potentiel de masse GND. Ensuite, pour écrire dans la cellule, la ligne de mot WL est mise au potentiel VDD. Une opération d'écriture est correctement réalisée lorsque la tension du noeud de stockage de niveau logique '1', par exemple le premier noeud T, devient inférieure à la tension de commutation du deuxième inverseur connecté au noeud de stockage de niveau logique '0', par exemple le deuxième noeud F. Une telle condition est liée au diviseur de tension entre la tension d'alimentation de la cellule VDD et la première ligne de bit $BL_T$, formé par le premier transistor de charge $TL_T$ et le premier transistor d'accès $TA_T$ connectés au noeud de stockage de niveau logique '1', par exemple le premier noeud T.

Afin d'obtenir une marge en écriture améliorée, les transistors sont mis en oeuvre de sorte que le courant de conduction $I_{ON-TAT}$ qui traverse le premier transistor d'accès $TA_T$ est supérieur au courant de conduction $I_{ON-TLT}$ du premier transistor de charge $TL_T$.

Un ratio de gain en courant q, entre les transistors de charge et d'accès $q=(W/L)_{TL}/(W/L)_{TA}$, avec $(W/L)_{TL}$ le rapport de la largeur cumulée de tous les canaux sur la longueur d'un desdits des canaux d'un transistor de charge et $(W/L)_{TA}$ le rapport de la largeur cumulée de tous les canaux sur la longueur d'un desdits canaux d'un transistor d'accès est prévu proche de 1, pour des transistors de dimension critique de grille de l'ordre de 90 nm.

Dans les cellules mémoires dotées de transistors comportant des grilles inférieures à 65 nm, les fluctuations du procédé de réalisation des transistors peuvent influer sur la marge en écriture des cellules et induire une diminution du ratio q, ce qui, pour ces cellules suivant l'art antérieur, ne peut être compensé que par une augmentation de la taille des transistors d'accès et des transistors de conduction.

Une co-intégration de transistors de charge $TL_T$ et $TL_F$, dotés d'une structure multi-canaux verticale comportant k canaux, et de transistors d'accès $TA_T$ et $TA_F$ dotés d'une structure multi-canaux verticale comportant m canaux, avec un nombre m de canaux plus élevé que celui k des transistors de charge, permet d'obtenir un ratio q plus important que celui d'une cellule 6T classique à encombrement ou surface de cellule identique, afin d'améliorer la marge en écriture de la cellule.

La cellule mémoire 6T proposée, peut comporter ainsi des améliorations à la fois en termes de stabilité en lecture et de marge en écriture, par rapport à une cellule 6T classique, à surface de cellule identique.

La conception du point de vue du dimensionnement des transistors pour une cellule , peut être faite en deux étapes :

Dans un premier temps, on détermine un nombre de canaux pour chaque transistor en fonction du rôle de ce transistor. Le nombre de canaux affecté à un transistor dépend notamment du courant de conduction que l'on souhaite obtenir pour ce transistor et du nombre de canaux que l'on affecte aux autres transistors, afin d'ajuster les rapports ou ratios r et q.

Dans un deuxième temps, on peut affiner le dimensionnement du transistor au niveau de sa géométrie et en particulier de la longueur L respective des barreaux formant ses canaux et de la largeur W respective des barreaux formant ses canaux.

Selon un exemple, on peut prévoir un rapport de gain en courant entre les transistors de conduction et d'accès de l'ordre de 2, afin de garantir une bonne stabilité en lecture.

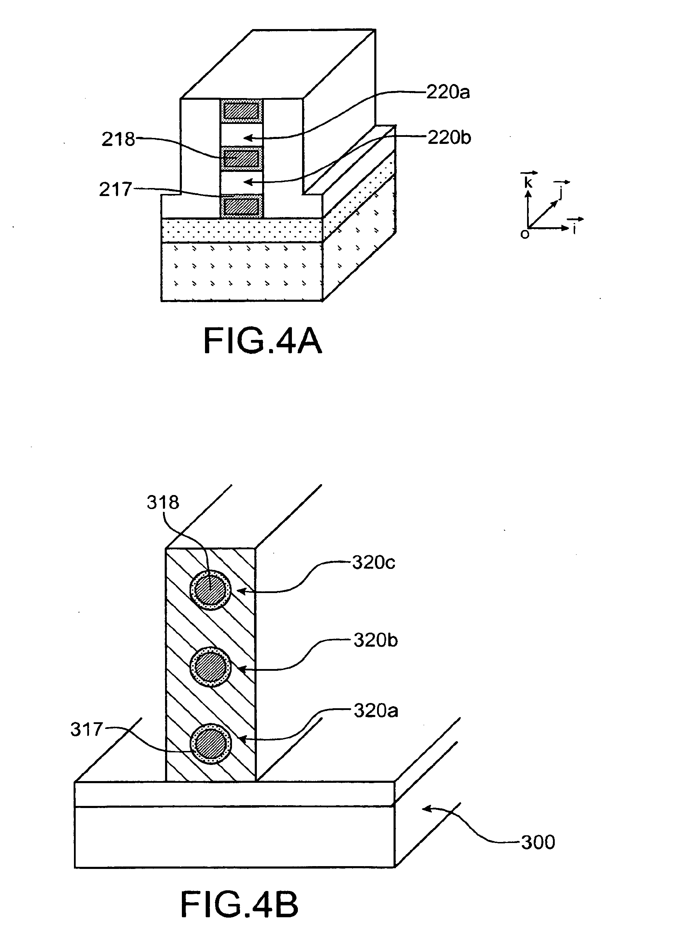

Le nombre de canaux X dans un transistor tel qu'illustré sur la figure 4A, peut être égal à : $X = 1+2*Y$, où Y est le nombre de barreaux, formant la structure multi-canaux. Le nombre de canaux X pour un transistor comportant une structure multi-canaux telle que donnée en liaison avec la figure 4A peut être choisi à l'aide du modèle suivant, tenant compte des résistances d'accès à la source et au drain :

$$I_{SAT\_x} = X * \alpha * 1/((\beta/ I_{SAT\_0}) + (R_X-R_0/Vdsat))$$

Avec :

- $I_{SAT\_X}$ : un courant de saturation souhaité pour le transistor,
- x : est le nombre total de canaux,
- $\alpha$ et $\beta$ : des paramètres de correction sans dimension tenant notamment compte d'effets de canal court,
- $I_{SAT\_0}$ : le courant de saturation d'un transistor de référence à canal unique, et de même longueur L que les barreaux dudit transistor multicanaux,
- $R_x$ une résistance d'accès moyenne effective vue par chaque canal du transistor multicanaux,
- Vdsat la tension de drain de saturation.

Pour obtenir un rapport de gain de 2 entre les transistors de conduction et d'accès, on peut prévoir un nombre de 9 canaux pour les transistors de conduction et un nombre de 5 canaux pour les transistors d'accès, ce qui peut permettre d'obtenir par exemple un rapport de gain de l'ordre de 1,48 en tenant compte de résistances d'accès qui diminueraient par exemple de l'ordre de 20 % le courant généré par canal supplémentaire. Pour une même densité d'intégration qu'une porte NAND2 de sortance 1.

Ensuite, pour fixer ce rapport de gain en courant entre les transistors d'accès et de conduction à une valeur de l'ordre de 2, on peut prévoir dans un deuxième temps, une largeur W des transistors de conduction 33 % supérieure à celle des transistors d'accès.

Selon ce même exemple, on peut également prévoir un rapport de gain en courant entre les transistors de charge et d'accès de l'ordre de 0,7, afin de garantir une bonne stabilité en écriture. Comme précédemment, pour obtenir ce gain, on peut prévoir un nombre de 3 canaux pour les transistors de charge par rapport à un nombre de 5 canaux pour les transistors d'accès, ce qui permet par exemple d'obtenir un rapport de gain de 0.68 en tenant compte de résistances d'accès.

Sur la figure 4A, un exemple de structure multi-canaux verticale d'un transistor susceptible d'être intégré à un dispositif, est donnée.

Dans cet exemple, la structure comporte, sur un support 200, une pluralité de barreaux semi-conducteurs 220a, 220b, alignés dans une direction orthogonale au plan principal du support 200 (le plan principal étant un plan défini par un plan du support parallèle au plan $[0; \vec{i}; \vec{j}]$ d'un repère $[O; \vec{i}; \vec{j}; \vec{k}]$.

Dans cet exemple, au moins une couche de matériau diélectrique de grille 217 et au moins une couche de matériau de grille 218 sont formées par-dessus et par-dessous les barreaux 220a, 220b semi-conducteurs.

Sur la figure 4B, un autre exemple de structure multi-canaux verticale d'un transistor susceptible d'être intégré à un dispositif , est donnée. Dans cet exemple, la structure est formée sur un support 200 d'une pluralité de barreaux semi-conducteurs 220a, 220b alignés dans une direction orthogonale au plan principal du support 200 (le plan principal étant un plan défini par un plan du support parallèle au repère $[O; \vec{i}; \vec{j}]$ d'un repère $[O; \vec{i}; \vec{j}; \vec{k}]$.

Dans cet exemple, au moins une couche de matériau diélectrique de grille 217 et au moins une couche de matériau de grille 218 sont formées autour des barreaux 220a, 220b semi-conducteurs.

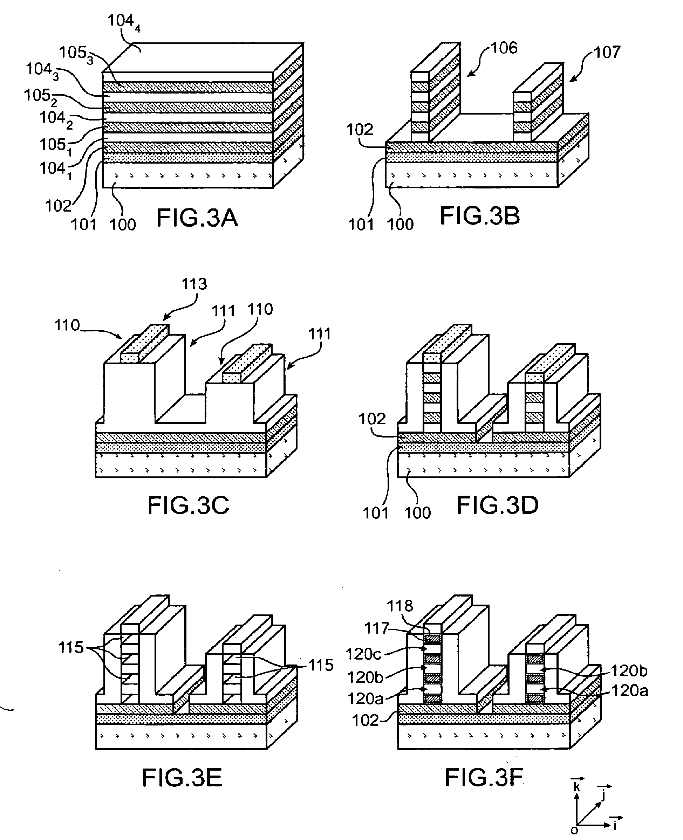

Un exemple de procédé de réalisation d'un dispositif comportant sur un même substrat, une pluralité de transistors dont au moins un transistor à structure multi-canaux verticale telle que décrite précédemment en liaison avec la figure 4A et ayant un nombre de canaux prédéterminé m et au moins un autre transistor à structure multi-canaux verticale (décrite également en liaison avec la figure 4A) ayant un nombre de canaux prédéterminé n tel que n > m, va à présent être donné en liaison avec les figures 3A-3F.

On réalise tout d'abord, sur un substrat, par exemple sur la couche semi-conductrice 102 d'un substrat 100 de type semi-conducteur sur isolant 101 tel qu'un substrat SOI (SOI pour « Silicon on Insulator » ou silicium sur isolant), un empilement 105 de couches semi-conductrices $104_1$, $105_1$,..., $104_4$, $105_3$, comprenant une alternance de couches $105_1$, $105_2$,..., $105_4$, à base d'un premier matériau semi-conducteur, tel que par exemple du Si, et de couches $104_1$, $104_2$, ..., $104_4$, à base d'un deuxième matériau différent du premier matériau semi-conducteur. Le deuxième matériau peut être un matériau semi-conducteur tel que par exemple du SiGe ou du Si dopé, par exemple du Si dopé au Phosphore, ou un matériau isolant tel que par exemple du $SiO_2$ (figure 3A).

Le deuxième matériau peut être un matériau prévu pour pouvoir être gravé de manière sélective vis-à-vis du premier matériau semi-conducteur. L'empilement 105 comporte un nombre de couches semiconductrices $104_1$, $105_1$,..., $104_4$, $105_3$, choisi en fonction du nombre de canaux que l'on souhaite réaliser pour chacune des structures multi-canaux verticales des transistors.

On grave ensuite cet empilement 105, de manière à former au moins un premier bloc 106 dans lequel une structure multi-canaux ayant un nombre de canaux prédéterminé m est destinée à être réalisée, et au moins un deuxième bloc 107 dans lequel une autre structure multi-canaux ayant un nombre de canaux prédéterminé n tel que n > m est destinée à être réalisée.

Le premier bloc 106 peut être formé par exemple d'un nombre choisi de barreaux empilés réalisés par exemple par photolithographie, puis gravure d'une première partie de l'empilement 105, à travers un masquage. Le deuxième bloc 107 peut, quant à lui, être formé par exemple d'un nombre de barreaux empilés choisi et inférieur au nombre de barreaux du premier bloc 106. Le deuxième bloc 107 peut être réalisé par exemple par photolithographie, puis gravure d'une deuxième partie de l'empilement 105 à travers un masquage.

Pour former le deuxième bloc 107, avec moins de barreaux empilés que le premier bloc 106, on peut, préalablement aux dites étapes de photolithographie et de gravure, avoir retiré une ou plusieurs couches de ladite deuxième partie de l'empilement 105 tout en ayant protégé à l'aide d'un masquage, ladite première partie de l'empilement 105 de ce procédé de retrait. Ce retrait peut s'effectuer par exemple à l'aide d'une gravure plasma avec un contrôle *in situ* des matériaux en présence lors de la gravure.

Selon une variante, pour former le deuxième bloc 107, avec moins de barreaux empilés que le premier bloc 106, un ou plusieurs barreaux dudit deuxième bloc 107 peuvent être retirés tandis que l'on protège à l'aide d'un masquage ledit premier bloc 106 du procédé de retrait. Un tel retrait peut être réalisé par exemple à l'aide d'une gravure plasma avec un contrôle *in situ* des matériaux en présence lors de la gravure.

Selon une possibilité de mise en oeuvre, la couche semi-conductrice 102, par exemple à base de Si, peut être gardée intacte, à l'aide également d'un masquage, lors de la formation des blocs 106 et 107 de barreaux empilés.

Ensuite, on forme des zones semiconductrices 110, 111, contre les flancs des blocs 106 et 107. Ces zones semi-conductrices sont prévues pour réaliser des régions de source et de drain et peuvent être formées par exemple par croissance par épitaxie sur la couche semi-conductrice 102. Les zones semi-conductrices de source et de drain peuvent être à base du deuxième matériau semi-conducteur, par exemple du Si. Pendant la croissance, les blocs 106, 107, peuvent être recouverts respectivement sur le dessus d'un masquage 113, par exemple à base de $Si_3N_4$ (figure 3C).

Ensuite, après une étape de photolithographie au cours de laquelle une partie des blocs 106, 107, est protégée, on grave les bords des zones semi-conductrices 110, 111, de manière à dévoiler les flancs des blocs 106, 107, situés aux extrémités des barreaux empilés. On peut également lors de cette étape, former au moins une tranchée 114 entre les blocs 106 et 107 afin de séparer les deux futurs transistors (figure 3D).

Puis, on effectue un retrait sélectif des barreaux à base du deuxième matériau, par exemple à base de SiGe, dans les blocs 106, et 107 de manière à conserver seulement les barreaux à base du premier matériau semi-conducteur, par exemple les barreaux à base de Si. Le retrait du deuxième matériau conduit à la réalisation d'espaces vides 115 entre les barreaux à base du premier matériau semi-conducteur (figure 3E). Ensuite, on effectue un remplissage desdits espaces vides à l'aide d'au moins un diélectrique 117 de grille, par exemple du $HfO_2$ ou du $SiO_2$, et d'au moins un matériau 118 de grille, par exemple du TiN ou un empilement de polySi et de TiN (figure 3F).

Puis, on réalise des grilles pour chacun des transistors en effectuant, par exemple des étapes de lithographie et de gravure de contacts de grille.

Un tel procédé permet de réaliser sur un même substrat 100 au moins un premier transistor, doté d'un nombre n (dans cet exemple égal à 3), canaux parallèles 120a, 120b, 120c et alignés dans une direction orthogonale avec le plan principal du substrat, et au moins un deuxième transistor, doté d'un nombre m (dans cet exemple égal à 2), tel que n > m, canaux parallèles 120a, 120b, dans une direction réalisant un angle non-nul, et alignés dans une direction orthogonal avec le plan principal du substrat (le plan principal du substrat, étant un plan passant par le substrat et parallèle à la couche 102 c'est-à-dire un parallèle au plan [O; $\vec{i}$ ; $\vec{k}$] d'un repère orthogonal [O; $\vec{i}$ ; $\vec{j}$ ; $\vec{k}$] défini sur la figure 3F) .

Un tel procédé n'est pas limité à la réalisation de deux structures multi-canaux différentes uniquement, et peut être mis en oeuvre également à la réalisation de plus de 2 structures multi-canaux différentes.

Un tel procédé est adapté en particulier pour la mise en oeuvre de transistors d'une cellule mémoire telle que décrite précédemment en liaison avec la figure 2, et qui comporte plusieurs transistors dotés respectivement d'une structure multi-canaux verticale à k canaux, plusieurs transistors dotés respectivement d'une structure multi-canaux verticale à n canaux, plusieurs transistors dotés respectivement d'une structure multi-canaux verticale à m canaux avec n ≠ k ≠ m, et n déterminé en fonction de m et éventuellement en fonction de k.

Le procédé qui vient d'être donné peut être mis en oeuvre pour former d'autres types de composants ou d'éléments que des mémoires et peut s'appliquer par exemple à la réalisation de composants ou d'éléments d'un dispositif microélectronique formant un circuit logique telle qu'une porte logique. Un tel procédé est également adapté pour la mise en oeuvre de transistors d'une porte logique, et qui comporte une pluralité de transistors dont un ou plusieurs transistors dotés respectivement d'une structures multi-canaux verticale à n canaux, et un ou plusieurs transistors dotés respectivement d'une structure multi-canaux verticale à k canaux, plusieurs transistors dotés respectivement d'une structure multi-canaux verticale à m canaux avec m ≠ k.

Une variante de procédé (non représentée) pour former les blocs 106, 107, va être donnée.

On réalise, tout d'abord, un dépôt d'une couche de masquage, par exemple isolante, sur la couche 102 semi-conductrice du substrat SOI de départ.

On réalise ensuite, une photolithogravure destinée à ouvrir la couche isolante de masquage dans une zone donnée, de manière à former une cavité. Un premier empilement formé alternativement de couches à base du premier matériau semi-conducteur et de couches à base du deuxième matériau est ensuite réalisée dans ladite cavité, par exemple par épitaxies successives.

Puis, on retire la couche isolante. Ces étapes sont ensuite réitérées afin de former un deuxième empilement, comportant un nombre de couche plus important que le premier empilement, et dans lequel un nombre de canaux plus important est destiné à être réalisé.

Les deux empilements sont ensuite gravés de manière à former les blocs 106 et 107.

Ce procédé peut être avantageusement utilisé dans le cadre de la conception et fabrication d'une porte logique de sortance améliorée. La sortance est une mesure de la capacité d'une porte logique à servir de source à d'autres portes logiques. La sortance d'une porte logique CMOS peut être par exemple quantifiée par rapport au temps de charge et de décharge de cette porte, une sortance de 1 correspondant à une porte chargée par elle-même, tandis qu'une sortance de 2 correspond à une porte chargée par deux portes de sortance 1 et ayant un temps de commutation identique. Deux paramètres de dimensionnement possibles de la porte logique peuvent être utilisés : un premier paramètre est la géométrie des transistors de la porte, plus particulièrement, la largeur respective W des canaux de la structure et la longueur respective L des canaux de la structure. Un deuxième paramètre est le nombre de canaux d'une structure multicanaux verticale que l'on prévoit pour chaque transistor de la porte, en fonction notamment d'un compromis entre une densité de courant recherchée pour ce transistor lorsqu'il conduit et une capacité de grille minimale pour une diminution de la puissance dynamique recherchée liée à ce transistor.

On peut ainsi mettre en oeuvre un circuit logique comportant :

- un ou plusieurs transistors pour lesquels on privilégie le courant débité, et auxquels, par exemple, un nombre n de canaux est affecté, et
- un ou plusieurs transistors pour lesquels on privilégie le gain en puissance dynamique, et auxquels, par exemple, un nombre m (avec m<n) de canaux est affecté.

Dans un cas où les résistances, d'accès au drain, et d'accès à la source, sont négligeables, une structure de transistor multi-canaux verticale dotée par exemple de 3 canaux, peut permettre de multiplier par un facteur de l'ordre de 3, le courant de saturation du transistor, par rapport à un transistor classique doté d'un seul canal de même géométrie que la géométrie respective des canaux de la structure multicanaux.

Le nombre de canaux X dans un transistor tel qu'illustré sur la figure 4A, en fonction de l'empilement est égal à : $X = 1+2*Y$, où Y est le nombre de barreaux formant la structure multi-canaux. Dans le cas ou les résistances d'accès ne sont pas négligeables : Selon un exemple, le nombre de canaux X pour un transistor comportant une structure multicanaux telle que donnée en liaison avec la figure 4A peut être choisi à l'aide du modèle suivant, tenant compte des résistances d'accès à la source et au drain :

$$I_{SAT\_x} = X * \alpha * 1/((\beta/ I_{SAT\_0}) + (R_X - R_0/Vdsat))$$

Avec :

- $I_{SAT\_X}$ : un courant de saturation souhaité pour le transistor,
- x : est le nombre total de canaux,
- $\alpha$ et $\beta$ : des paramètres de correction sans dimension tenant notamment compte des effets de canal court,
- $I_{SAT\_0}$ : le courant de saturation d'un transistor de référence à canal unique, et de même longueur L que les barreaux dudit transistor multicanaux,
- $R_x$ la résistance d'accès moyenne effective vue par chaque canal du transistor multi-canaux,
- Vdsat la tension de drain de saturation.

Un premier avantage apporté par la mise en oeuvre de transistors multi-canaux pour réaliser une porte logique est le suivant :

Si l'on souhaite réaliser par exemple une porte logique de type NAND2 c'est-à-dire une porte NON-ET à 2 entrées avec une sortance de 3, la cellule doit de préférence être capable de fournir ou d'absorber 3 fois plus de courant qu'une porte NON-ET à 2 entrées de sortance 1. Pour cela, on peut prévoir un nombre de 2 canaux supplémentaires par rapport à un transistor mono-canal, ce qui peut permettre d'obtenir un gain en ce qui concerne le courant de saturation total par exemple de l'ordre de 2,4, en tenant compte de résistance d'accès.

Si l'on considère une augmentation linéaire du courant de saturation avec la largeur W des transistors, une augmentation de l'ordre de 25 % la largeur du transistor aurait permis d'atteindre le même objectif de 3 fois plus de courant, avec un transistor mono-canal.

Autrement dit, la mise en oeuvre d'une telle porte logique à l'aide de transistors dotés d'une structure multicanaux permet de réaliser un gain de surface de l'ordre de 75 % par rapport à une conception avec des transistors mono-canal, à performances électriques identiques.

Un deuxième avantage apporté par l'intégration de transistors à structure multi-canaux verticale pour la mise en oeuvre d'une porte logique est d'obtenir des temps de montée et de descente équilibrés. Le dimensionnement de la porte logique peut être basé sur deux paramètres :

- le rapport de mobilité entre les transistors de type N et les transistors de type P, et
- le nombre de transistors en cascade ou empilé, par exemple par branche entre la sortie de la porte et un potentiel d'alimentation. Par exemple, pour mettre en oeuvre une porte logique de type NAND3 de sortance 2 avec un rapport de mobilité considéré : $\mu n/\mu p = 2$ entre transistors de type N et transistors de type P, on peut prévoir un nombre de 5 canaux supplémentaires et de 7 canaux supplémentaires par rapport à un transistor mono-canal pour les transistors NMOS et PMOS respectivement, en considérant un cas où les résistances d'accès dégraderaient de 20 % le courant généré par canal supplémentaire. Il en résulte un courant total de saturation des PMOS 4 fois plus important que pour un canal et 5, 6 fois plus important pour les NMOS. Cela peut permettre également à performances électriques identiques d'obtenir une surface occupée réduite d'un facteur 4 pour les transistors de type P et d'un facteur 5.6 pour les transistors de type N.

On peut ainsi mettre en oeuvre un circuit logique comportant :

- un ou plusieurs transistors d'un premier type, en particulier de type P avec une structure multi-canaux verticale comportant n canaux, et
- un ou plusieurs transistors d'un deuxième type, en particulier de type N avec une structure multi-canaux verticale comportant m canaux (avec n > m).

Une variante de l'exemple du procédé de réalisation d'un dispositif comportant sur un même substrat, une pluralité de transistors dont au moins un transistor à structure multi-canaux verticale ayant un nombre de canaux prédéterminé m et au moins un autre transistor à structure multi-canaux verticale ayant un nombre de canaux prédéterminé n tel que n > m, suivant l'invention, va à présent être donnée en liaison avec les figures 5A-5B.

On réalise tout d'abord, sur le substrat 100, en particulier sur une première zone de la couche semi-conductrice 102 du substrat 100, un empilement de couches semi-conductrices $104_1$, $105_1$,..., $104_3$, comprenant une alternance de couches 102, $105_1$, $105_2$ à base d'un premier matériau semi-conducteur, tel que par exemple du Si, et de couches $104_1$, $104_2$, $104_3$, à base d'un deuxième matériau, différent du premier matériau semi-conducteur. Le deuxième matériau peut être un matériau prévu pour pouvoir être gravé de manière sélective vis-à-vis du premier matériau semi-conducteur.

L'empilement 205 comporte un nombre de couches semi-conductrices choisi en fonction du nombre de canaux que l'on souhaite réaliser pour chacune des structures multi-canaux verticales des transistors.

Ce premier empilement forme un premier bloc 206 dans lequel ou sur lequel une structure multicanaux ayant un nombre de canaux prédéterminé m est destinée à être réalisée, est formé. Le premier empilement peut être été formé par exemple par une ou plusieurs épitaxies sur la première zone tandis que les autres zones de la couche semi-conductrice sont protégées, par exemple à l'aide d'un masquage, par exemple à base de $SiO_2$.

On réalise ensuite sur une deuxième zone de la couche semi-conductrice 102 du substrat 100, un deuxième empilement de couches semi-conductrices $204_1$, $205_1$, $204_2$, comprenant une alternance de couches à base dudit premier matériau et de couches à base dudit deuxième matériau. Le deuxième empilement peut être formé par exemple par une ou plusieurs épitaxies tandis que le premier empilement est protégé, par exemple à l'aide d'un masquage, par exemple à base de $SiO_2$, qui est ensuite retiré (figure 5A).

La première zone et la deuxième zone peuvent avoir été formées par gravure de la couche semi-conductrice 102 et de la couche isolante du substrat.

Ce deuxième empilement peut être formé avec une épaisseur de même hauteur que le premier empilement, tout en comportant moins de couches que le premier empilement. Pour cela, certaines couches $204_1$, $205_1$ de l'empilement peuvent être formées avec des épaisseurs plus importantes que celles des autres couches et en particulier des couches du premier empilement (figure 5B).

Ensuite, on peut mettre en oeuvre des étapes telles que décrites précédemment en liaison avec les figures 3A-3F.

<u>DOCUMENTS CITES</u> :

[TAK' 01] : K. Takeuchi, et al.,« A Study of Threshold Voltage Variation for Ultra SmallBulk and SOI...CMOS.», IEEE TED, VOL.48, No.9, September 2004.

[YAM'04] : M. YAMAOKA, et al., «Low Power SRAM Menu for SOC Application Using Yin-Yang-Feedback memory Cd1 Technology », Symposium on VLSI circuits, Digest of Technical Papers, Honolulu, USA, June 2004.

**Revendications**

1.   Dispositif microélectronique, comprenant, sur un substrat au moins un élément comportant :

   - un ou plusieurs premier(s) transistor(s), doté(s), dans une direction réalisant un angle non-nul avec le plan principal du substrat, d'un nombre n de canaux parallèles sous forme d'une pluralité de barreaux semi-conducteurs parallèles entre eux et au substrat, les barreaux étant formés dans un premier empilement comportant un premier nombre de couches semi-conductrices,

- **caractérisé par** un ou plusieurs deuxième(s) transistor(s), doté(s) dans une direction réalisant un angle non-nul avec le plan principal du substrat, d'un nombre m, tel que n > m de canaux parallèles sous forme d'une pluralité de barreaux semi-conducteurs parallèles entre eux et au substrat, les barreaux étant formés dans un deuxième empilement comportant un deuxième nombre de couches semi-conductrices inférieur à celui dudit premier empilement,

ledit premier empilement et ledit deuxième empilement étant de même hauteur, le deuxième empilement comportant une ou plusieurs couches semi-conductrices d'épaisseur(s) supérieure(s) à celles des couches du premier empilement.

2.  Dispositif microélectronique selon la revendication 1, dans lequel ledit élément est une cellule mémoire statique à accès aléatoire, la cellule comportant :

- au moins un transistor d'accès ($TA_T$) et au moins un autre transistor d'accès ($TA_F$) dotés respectivement d'un nombre m de canaux parallèles dans une direction réalisant un angle non-nul avec le plan principal du substrat,
- une pluralité de transistors formant une bascule dont au moins un transistor de conduction ($TD_T$) et au moins un autre transistor de conduction ($TD_F$) dotés respectivement d'un nombre n, de canaux parallèles dans une direction réalisant un angle non-nul, de préférence une direction orthogonale, avec le plan principal du substrat, n étant prévu supérieur à m.

3.  Dispositif microélectronique selon l'une des revendications 1 ou 2, dans lequel ledit élément est une cellule mémoire statique à accès aléatoire, la cellule comportant :

- au moins un transistor d'accès ($TA_T$) et au moins un autre transistor d'accès ($TA_F$) dotés respectivement d'un nombre m de canaux parallèles dans une direction réalisant un angle non-nul avec le plan principal du substrat,
- une pluralité de transistors formant une bascule, dont au moins un transistor de charge ($TL_T$) et au moins un autre transistor de charge ($TL_F$) dotés respectivement d'un nombre k, de canaux parallèles dans une direction réalisant un angle non-nul, de préférence une direction orthogonale, avec le plan principal du substrat, m étant prévu supérieur à k.

4.  Dispositif microélectronique de mémoire vive à accès aléatoire (RAM), comprenant une pluralité de cellules suivant l'une des revendications 2 ou 3.

5.  Dispositif microélectronique, selon la revendication 1, dans lequel ledit élément est une porte logique ou un circuit logique comportant une ou plusieurs portes logiques.

6.  Dispositif microélectronique, selon la revendication 5, lesdits premier(s) transistor(s), étant des transistors d'un premier type, entre un type P et un type N,
    lesdits deuxième(s) transistor(s), étant des transistors d'un deuxième type, entre un type P et un type N, et différent du premier type.

7.  Procédé de réalisation d'un dispositif microélectronique, comprenant, la formation sur un substrat d'un ou plusieurs éléments comportant :

- un ou plusieurs premier(s) transistor(s), doté(s), dans une direction réalisant un angle non-nul avec le plan principal du substrat, respectivement d'un nombre m de canaux sous forme d'une pluralité de barreaux semi-conducteurs parallèles entre eux et au substrat lesdits m canaux des premier(s) transistor(s) sont formés dans un premier empilement comportant un premier nombre de couches semi-conductrices,
- **caractérisé par** un ou plusieurs deuxième(s) transistor(s) doté(s), dans une direction réalisant un angle non-nul avec le plan principal du substrat respectivement d'un nombre n, tel que n > m, canaux sous forme d'une pluralité de barreaux semi-conducteurs parallèles entre eux et au substrat lesdits n canaux des deuxième(s) transistor(s) sont formés dans un deuxième empilement comportant un deuxième nombre de couches semi-conductrices inférieur à celui du premier empilement, ledit premier empilement et le deuxième empilement étant de même hauteur, le deuxième empilement comportant une ou plusieurs couches semi-conductrices d'épaisseur (s) supérieure(s) à celles des couches du premier empilement.

**8.** Procédé selon la revendication selon la revendication 7, le premier empilement et le deuxième empilement étant formés d'une alternance de couches semi-conductrices à base d'un premier matériau semiconducteur et de couches semi-conductrices à base d'un deuxième matériau semi-conducteur.

**9.** Procédé selon l'une des revendications 7 ou 8, dans lequel lesdits éléments comportent des cellules d'une mémoire SRAM.

**10.** Procédé selon l'une des revendications 7 à 9, dans lequel lesdits éléments comportent une porte logique ou un circuit logique comportant une ou plusieurs portes logiques.

**11.** Procédé selon la revendication 10, lesdits premier(s) transistor(s), étant des transistors d'un premier type, entre un type P et un type N, lesdits deuxième(s) transistor(s), étant des transistors d'un deuxième type, entre un type P et un type N, différent du premier type.


**Patentansprüche**

**1.** Mikroelektronische Vorrichtung, die auf einem Substrat zumindest ein Element aufweist, das enthält:

    - einen oder mehrere erste(n) Transistor(en), der/die in einer Richtung, die mit der Hauptebene des Substrats einen Winkel ungleich null einschließt, mit einer Anzahl n von parallel verlaufenden Kanälen in Form von einer Mehrzahl von Halbleiterstäben, die parallel zueinander und zum Substrat verlaufen, versehen ist/sind, wobei die Stäbe in einem ersten Stapel ausgebildet sind, der eine erste Anzahl von Halbleiterschichten aufweist, **gekennzeichnet durch**
    - einen oder mehrere zweite(n) Transistor(en), der/die in einer Richtung, die mit der Hauptebene des Substrats einen Winkel ungleich null einschließt, mit einer Anzahl m, so dass n > m, von parallel verlaufenden Kanälen in Form von einer Mehrzahl von Halbleiterstäben, die parallel zueinander und zum Substrat verlaufen, versehen ist/sind, wobei die Stäbe in einem zweiten Stapel ausgebildet sind, der eine zweite Anzahl von Halbleiterschichten aufweist, die geringer als die des ersten Stapels ist,
    wobei der erste Stapel und der zweite Stapel von gleicher Höhe sind, wobei der zweite Stapel eine oder mehrere Halbleiterschicht(en) aufweist, deren Dickenwerte höher sind als die des ersten Stapels.

**2.** Mikroelektronische Vorrichtung nach Anspruch 1, wobei das Element eine statische RAM-Speicherzelle ist, wobei die Zelle enthält:

    - zumindest einen Zugriffstransistor ($TA_T$) und zumindest einen weiteren Zugriffstransistor ($TA_F$), die jeweils mit einer Anzahl m von parallelen Kanälen in einer Richtung versehen sind, die mit der Hauptebene des Substrats einen Winkel ungleich null einschließt,
    - eine Mehrzahl von Transistoren, die ein Füpflop bilden, darunter zumindest ein Leitungstransistor ($TD_T$) und zumindest ein weiterer Leitungstransistor ($TD_F$), die jeweils mit einer Anzahl n von parallelen Kanälen in einer Richtung versehen sind, die mit der Hauptebene des Substrats einen Winkel ungleich null einschließt, vorzugsweise in einer orthogonal verlaufenden Richtung, wobei n größer als m vorgesehen ist.

**3.** Mikroelektronische Vorrichtung nach einem der Anspräche 1 oder 2, wobei das Element eine statische RAM-Speicherzelle ist, wobei die Zelle enthält:

    - zumindest einen Zugriffstransistor ($TA_T$) und zumindest einen weiteren Zugriffstransistor ($TA_F$), die jeweils mit einer Anzahl m von parallelen Kanälen in einer Richtung versehen sind, die mit der Hauptebene des Substrats einen Winkel ungleich null einschließt,
    - eine Mehrzahl von Transistoren, die ein Flipflop bilden, darunter zumindest ein Lasttransistor ($TL_T$) und zumindest ein weiterer Lasttransistor ($TL_F$), die jeweils mit einer Anzahl k von parallelen Kanälen in einer Richtung versehen sind, die mit der Hauptebene des Substrats einen Winkel ungleich null einschließt, vorzugsweise in einer orthogonale verlaufenden Richtung, wobei m größer als k vorgesehen ist.

**4.** Mikroelektronische Vorrichtung mit RAM-Speicher, enthaltend eine Mehrzahl von Zellen nach einem der Ansprüche 2 oder 3.

**5.** Mikroelektronische Vorrichtung nach Anspruch 1, wobei das Element ein Logikgatter oder eine Schaltung mit einem oder mehreren Logikgattern ist.

**6.** Mikroelektronische Vorrichtung nach Anspruch 5, wobei es sich bei dem/den ersten Transistor(en) um Transistoren eines ersten Typs zwischen einem P-Typs und einem N-Typ handelt,
wobei es sich bei dem/den zweiten Transistor(en) um Transitoren eines zweiten Typs zwischen einem P-Typ und einem N-Typ handelt, der sich vom ersten Typ unterscheidet.

**7.** Verfahren zum Herstellen einer mikroelektronischen Vorrichtung, das die auf einem Substrat vorgesehene Bildung eines oder mehrerer Elemente umfasst, enthaltend:

- einen oder mehrere erste(n) Transistor(en), der/die in einer Richtung, die mit der Hauptebene des Substrats einen Winkel ungleich null einschließt, jeweils mit einer Anzahl m von Kanälen in Form von einer Mehrzahl von Halbleiterstäben, die parallel zueinander und zum Substrat verlaufen, versehen ist/sind, wobei die m Kanäle des/der ersten Transistors bzw. Transistoren in einem ersten Stapel ausgebildet sind, der eine erste Anzahl von Halbleiterschichten aufweist, **gekennzeichnet durch**
- einen oder mehrere zweite(n) Transistor(en), der/die in einer Richtung, die mit der Hauptebene des Substrats einen Winkel ungleich null einschließt, jeweils mit einer Anzahl n, so dass n > m, von Kanälen in Form von einer Mehrzahl von Halbleiterstäben, die parallel zueinander und zum Substrat verlaufen, versehen ist/sind, wobei die n Kanäle des/der zweiten Transistors bzw. Transistoren in einem zweiten Stapel ausgebildet sind, der eine zweite Anzahl von Halbleiterschichten aufweist, die geringer als die des ersten Stapels ist, wobei der erste Stapel und der zweite Stapel von gleicher Höhe sind, wobei der zweite Stapel eine oder mehrere Halbleiterschicht (en) aufweist, deren Dickenwerte höher sind als die des ersten Stapels.

**8.** Verfahren nach Anspruch 7, wobei der erste Stapel und der zweite Stapel aus einer Wechselfolge von Halbleiterschichten auf Basis von einem ersten Halbleitermaterial und von Halbleiterschichten auf Basic von einem zweiten Halbleitermaterial gebildet sind.

**9.** Verfahren nach einem der Ansprüche 7 oder 8, wobei die Elemente Zellen eines SRAM-Speichers enthalten.

**10.** Verfahren nach einem der Ansprüche 7 bis 9, wobei die Elemente ein Logikgatter oder eine Schaltung mit einem oder mehreren Logikgattern aufweisen.

**11.** Verfahren nach Anspruch 10, wobei es sich bei dem/den ersten Transistor(en) um Transistoren eines ersten Typs zwischen einem P-Typ und einem N-Typ handelt,
wobei es sich bei dem/den zweiten Transistor(en) um Transistoren eines zweiten Typs zwischen einem P-Typ und einem N-Typ handelt, der sich vom ersten Typ unterscheidet.

**Claims**

**1.** A microelectronic device comprising, on a substrate, at least one element comprising:

- one or more first transistors provided, in a direction forming a non-zero angle with the main plane of the substrate, with a number n of parallel channels in the form of a plurality of bars parallel to each other and to the substrate, said bars being formed in a first stack comprising a first number of semiconductor layers,
- one or more second transistors provided, in a direction forming a non-zero angle with the main plane of the substrate, with a number m of parallel channels such that n > m in the form of a plurality of bars parallel to each other and to the substrate, said bars being formed in a second stack comprising a second number of semiconductor layers lower than the number of layers of said first stack,
said first stack and said second stack being of the same height, said second stack comprising one or more layers having thickness(es) higher than that of the layers of said first stack.

**2.** The microelectronic device according to claim 1, wherein said element is a static random access memory cell, the cell comprising:

- at least one access transistor ($TA_T$) and at least one other access transistor ($TA_F$) respectively provided with a number m of channels parallel in a direction forming a non-zero angle with the main plane of the substrate,
- a plurality of transistors forming a flip-flop including at least one conduction transistor ($TD_T$) and at least one other conduction transistor ($TD_F$) respectively provided with a number n of channels parallel in a direction forming a non-zero angle, preferably an orthogonal direction, with the main plane of the substrate, n being greater than m.

3. The microelectronic device according to claim 1 or 2, wherein said element is a static random access memory cell, the cell comprising:

- at least one access transistor ($TA_T$) and at least one other access transistor ($TA_F$) respectively provided with a number m of channels parallel in a direction forming a non-zero angle with the main plane of the substrate,
- a plurality of transistors forming a flip-flop, including at least one charge transistor ($TL_T$) and at least one other charge transistor ($TL_F$) respectively provided with a number k of channels parallel in a direction forming a non-zero angle, preferably an orthogonal direction, with the main plane of the substrate, m being greater than k.

4. The microelectronic device with random access memory (RAM), comprising a plurality of cells according to claim 2 or 3.

5. The microelectronic device according to claim 1, wherein said element is a logic gate or a logic circuit comprising one or more logic gates.

6. The microelectronic device according to claim 5, said first transistor(s) being transistors of a first type between a P-type and an N-type,
said second transistor(s) being transistors of a second type, between a P-type and an N-type, and different from the first type.

7. A method to form a microelectronic device comprising the forming on a substrate of one or more elements, comprising:

- one or more first transistors respectively provided, in a direction forming a non-zero angle with the main plane of the substrate, with a number m of channels in the form of a plurality of bars parallel to each other and to the substrate, said bars being formed in a first stack comprising a first number of semiconductor layers,
- one or more second transistors respectively provided, in a direction forming a non-zero angle with the main plane of the substrate, with a number n of channels, such that n > m, in the form of a plurality of bars parallel to each other and to the substrate, said bars being formed in a second stack comprising a second number of semiconductor layers lower than the number of layers of said first stack,
said first stack and said second stack being of the same height, said second stack comprising one or more layers having thickness(es) higher than that of the layers of said first stack.

8. The method according to claim 7, wherein said m channels of the first transistor(s) are formed in a first stack comprising a first number of semiconductor layers, said n channels of the first transistor(s) being formed in a second stack comprising a second number of semiconductor layers different from the first number.

9. The method according to claim 7 or 8, wherein said elements comprise cells of a SRAM memory.

10. The method according any of claims 7 to 9, wherein said elements comprise a logic gate or a logic circuit comprising one or more logic gates.

11. The method according to claim 10, said first transistor(s) being transistors of a first type, between a P-type and an N-type, said second transistor(s) being transistors of a second type, between a P-type and an N-type, different from the first type.

# FIG.1

# FIG.2

FIG.3A

FIG.3B

FIG.3C

FIG.3D

FIG.3E

FIG.3F

FIG.4A

FIG.4B

206

$104_3$

$105_2$

$104_2$

$105_1$

$104_1$

102

FIG.5A

206

207

$104_3$

$104_3$

$104_3$

102

e
e

e'

FIG.5B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050161739 A
- WO 2006108987 A1

- US 5965914 A

**Littérature non-brevet citée dans la description**

- **K. TAKEUCHI et al.** A Study of Threshold Voltage Variation for Ultra SmallBulk and SOI...CMOS. *IEEE TED,* Septembre 2004, vol. 48 (9

- **M. YAMAOKA et al.** Low Power SRAM Menu for SOC Application Using Yin-Yang-Feedback memory Cd1 Technology. *Symposium on VLSI circuits, Digest of Technical Papers,* Juin 2004